# FASCICULE DE BREVET EUROPEEN

(11) **EP 3 890 003 B1**
(45) Date de publication et mention de la délivrance du brevet: **29.06.2022**
(21) Numéro de dépôt: 21165568.3
(22) Date de dépôt: 29.03.2021
(51) Int. Cl.: H01L 21/762, H01L 27/06, H01L 21/18, H01L 21/822, H01L 21/322

(54) **PROCÉDÉ BASSE TEMPÉRATURE DE TRANSFERT ET DE GUÉRISON D'UNE COUCHE SEMICONDUCTRICE**
NIEDRIGTEMPERATURVERFAHREN ZUR ÜBERTRAGUNG UND AUSHEILUNG EINER HALBLEITERSCHICHT
METHOD FOR LOW-TEMPERATURE TRANSFER AND RECOVERY OF A SEMICONDUCTOR LAYER

(30) Priorité: 31.03.2020 FR 2003199
(43) Date de publication de la demande: 06.10.2021
(73) Titulaire: Commissariat à l'énergie atomique et aux énergies alternatives, 75015 Paris (FR)
(72) Inventeur: REBOH, Shay, 38054 GRENOBLE Cedex 09 (FR)
(74) Mandataire: Brevalex

(56) Documents cités:
- FR-A1- 3 045 934
- FR-A1- 3 045 935
- FR-A1- 3 063 834

## Description

### DOMAINE TECHNIQUE

Le domaine de l'invention est celui des circuits intégrés dotés de composants microélectroniques répartis sur plusieurs niveaux, en particulier des transistors superposés. De tels circuits sont généralement qualifiés de dispositifs intégrés en 3 dimensions ou « 3D ». L'invention vise plus spécifiquement un procédé de réalisation d'un tel dispositif à composants superposés au moyen d'un transfert sur un premier niveau de composants d'une couche monocristalline destinée à servir à la fabrication d'un deuxième niveau de composants.

### TECHNIQUE ANTÉRIEURE

D'une manière générale, dans le domaine des circuits intégrés, on cherche continuellement à augmenter la densité de transistors. Pour cela, une solution consiste à répartir les transistors sur plusieurs niveaux de couches semi-conductrices disposées les unes au-dessus des autres pour former un dispositif 3D. Un tel dispositif 3D comporte ainsi généralement un niveau inférieur doté d'une première couche semi-conductrice à partir de laquelle des transistors sont formés et au moins un niveau supérieur doté d'au moins une deuxième couche semi-conductrice à partir de laquelle des transistors sont formés, la première et la deuxième couche semi-conductrice étant superposées.

La réalisation du dispositif 3D peut impliquer la mise en œuvre d'une étape d'assemblage d'un niveau inférieur dans lequel des transistors ont par exemple déjà été réalisés et d'un substrat silicium sur isolant (SOI pour « Silicon On Insulator ») dans lequel on retrouve la couche semi-conductrice d'un niveau supérieur. L'assemblage entre le substrat SOI et le niveau inférieur est généralement effectué par collage.

Le substrat SOI est ensuite aminci jusqu'à la couche semi-conductrice du niveau supérieur. Cet amincissement peut être réalisé par gravure de la face arrière du substrat SOI. De manière alternative, la couche semi-conductrice du niveau supérieur peut être transférée sur le niveau inférieur conformément au procédé Smart Cut^{™} depuis le substrat SOI. Ce transfert comprend, préalablement au collage, l'implantation d'espèces ioniques dans le substrat SOI de sorte à former un plan de fragilisation et, après le collage, la fracture du substrat SOI le long du plan de fragilisation.

Dans les deux cas de figure, la couche d'oxyde enterrée (BOX pour « Buried OXide ») du substrat SOI sert de couche d'arrêt à la gravure d'amincissement, ce qui permet d'obtenir une fine couche semi-conductrice en silicium d'épaisseur uniforme. Ces deux méthodes présentent cependant l'inconvénient d'être relativement coûteuses du fait du coût de fabrication du substrat SOI.

Une solution pour réduire ces coûts consisterait à fabriquer la couche semi-conductrice du niveau supérieur par Smart Cut^{™} non pas à partir d'un substrat SOI mais directement à partir d'un substrat de silicium massif.

Afin d'assurer une rectification de la rugosité de surface post-fracture et d'amincir la couche semi-conductrice à l'épaisseur souhaitée, des procédés tels que des oxydations thermiques présentant un important budget thermique, par exemple de l'ordre de 900-1200°C, sont conventionnellement réalisés. Un tel budget thermique peut entraîner une dégradation des composants du niveau inférieur de sorte que ces procédés ne sont pas adaptés pour la conception de circuits 3D.

Il est par ailleurs nécessaire d'éliminer des défauts susceptibles d'affecter la mobilité des porteurs de charge qui ont été introduits par l'implantation d'espèces ioniques dans la matrice cristalline de la couche semi-conductrice du niveau supérieur. Une guérison de ces défauts peut conventionnellement être obtenue au moyen d'un traitement thermique à des températures supérieures à 900°C. Un tel traitement thermique est lui aussi susceptible de venir dégrader les composants du niveau inférieur, et cette guérison ne peut donc être mise en oeuvre dans le cadre d'une conception de dispositifs 3D. FR3045934 A1

décrit un procédé de fabrication d'un empilement de dispositifs électroniques comprenant une étape de cristallisation du film amorphe présent dans l'empilement. FR3063834 A1 décrit un procédé de fabrication d'un dispositif semi-conducteur tridimensionnel, dans lequel le transfert de l'empilement comprend une gravure sélective de la couche d'arrêt de gravure. FR3045935 A1 décrit un procédé de fabrication d'un empilement de dispositifs électroniques, comportant des étapes d'amorphisation d'une couche polycristalline et de recristallisation de la partie amorphe après l'étape d'introduction des dopants dans la partie amorphe.

### EXPOSÉ DE L'INVENTION

Un objectif de l'invention est de proposer un procédé de conception de dispositifs 3D dans lequel la couche cristalline du niveau supérieur serait obtenue par transfert à partir d'un substrat de silicium massif et dans lequel la rectification de la rugosité de surface post-fracture, la maîtrise de l'épaisseur de la couche transférée et la guérison des défauts présents dans celle-ci pourraient être obtenues sans dégradation des composants du niveau inférieur.

Elle propose pour ce faire un procédé de réalisation d'un substrat de type semi-conducteur sur isolant, comprenant les étapes suivantes :
a) fourniture d'un substrat donneur comprenant un substrat support monocristallin, une couche de lissage et une couche semi-conductrice, la couche de lissage formant une couche d'arrêt à la gravure vis-à-vis du matériau du substrat support ;
a') implantation d'espèce ioniques au travers de la couche semi-conductrice de sorte à former un plan de fragilisation ;
b) réalisation d'un assemblage par mise en contact du substrat donneur et d'un substrat receveur ;
c) transfert sur le substrat receveur de la couche semi-conductrice et d'au moins une partie de la couche de lissage par détachement le long du plan de fragilisation ;
la couche semi-conductrice du substrat donneur fourni à l'étape a) est monocristalline et le procédé comprenant en outre les étapes suivantes :
- avant l'étape b), amorphisation d'au moins une partie de la couche semi-conductrice pour former une couche amorphe ;
- pendant ou après l'étape c), recristallisation en phase solide de la couche amorphe pour former une couche semi-conductrice monocristalline transférée.

Certains aspects préférés mais non limitatifs de ce procédé sont les suivants :
ladite recristallisation est suivie d'une amorphisation de la couche semi-conductrice monocristalline transférée pour former une nouvelle couche amorphe et d'une recristallisation en phase solide de la nouvelle couche amorphe pour former une nouvelle couche semi-conductrice monocristalline transférée ;
il comprend en outre un retrait d'une couche riche en atomes interstitiels présente en surface de la couche semi-conductrice monocristalline transférée ;
ledit retrait comprend une oxydation assistée par plasma suivie d'une gravure chimique ;
l'amorphisation d'au moins une partie de la couche semi-conductrice comprend l'amorphisation de l'intégralité de la couche semi-conductrice ;
l'amorphisation d'au moins une partie de la couche semi-conductrice comprend l'amorphisation conjointe de la couche semi-conductrice et de la couche de lissage ;
l'étape d) comprend en outre la réalisation d'une gravure sélective de la couche de lissage ;
le substrat donneur fourni à l'étape a) comprend en outre une couche intermédiaire et une couche d'amincissement interposée entre la couche intermédiaire et la couche semi-conductrice, la couche d'amincissement formant une couche d'arrêt à la gravure vis-à-vis du matériau de la couche semi-conductrice et l'étape d) comprend en outre la réalisation successive d'une gravure sélective de la couche de lissage par rapport à la couche intermédiaire, d'une gravure sélective de la couche intermédiaire par rapport à la couche d'amincissement et d'une gravure sélective de la couche d'amincissement par rapport à la couche semi-conductrice ;
l'amorphisation d'au moins une partie de la couche semi-conductrice comprend l'amorphisation conjointe de la couche semi-conductrice et d'au moins une partie de la couche d'amincissement ;
l'amorphisation d'au moins une partie de la couche semi-conductrice comprend l'amorphisation conjointe de la couche semi-conductrice, de la couche d'amincissement et d'au moins une partie de la couche intermédiaire;
l'amorphisation d'au moins une partie de la couche semi-conductrice comprend l'amorphisation conjointe de la couche semi-conductrice, de la couche d'amincissement, de la couche intermédiaire et d'au moins une partie de la couche de lissage ;
il comprend, avant l'amorphisation d'au moins une partie de la couche semi-conductrice, la formation sur la couche semi-conductrice, par oxydation thermique à une température de préférence inférieure à 800°C, d'une couche diélectrique d'épaisseur comprise par exemple entre 5 nm et 25 nm, ladite couche diélectrique étant à l'étape b) à l'interface des substrats donneur et receveur mis en contact ;
ladite formation comprend en outre, après l'amorphisation d'au moins une partie de la couche semi-conductrice, un épaississement de la couche diélectrique ;
il comprend en outre avant l'étape b) une implantation d'espèces ioniques dans le substrat support de sorte à former un plan de fragilisation et l'étape c) comprend le détachement du substrat support la long du plan de fragilisation ;
il comprend en outre, après la formation de la couche amorphe et avant ladite implantation, le dépôt d'une ou plusieurs couches sur le substrat donneur ;
le substrat receveur intègre un niveau de composants microélectroniques.
un procédé de réalisation d'un substrat de type semi-conducteur sur isolant, selon une variante, peut comprendre les étapes suivantes :
   a) fourniture d'un substrat donneur comprenant un substrat support monocristallin, une couche de lissage et une couche semi-conductrice, la couche de lissage formant une couche d'arrêt à la gravure vis-à-vis du matériau du substrat support ;
   b) réalisation d'un assemblage par mise en contact du substrat donneur et d'un substrat receveur ;
   c) transfert sur le substrat receveur de la couche semi-conductrice, de la couche de lissage et d'une partie du substrat support ;
   d) la réalisation d'une gravure sélective de ladite partie du substrat support par rapport à la couche de lissage ;
   la couche semi-conductrice du substrat donneur fourni à l'étape a) étant monocristalline et le procédé comprend en outre les étapes suivantes :
   - avant l'étape b), amorphisation d'au moins une partie de la couche semi-conductrice pour former une couche amorphe ;
   - pendant ou après l'étape c), recristallisation en phase solide de la couche amorphe pour former une couche semi-conductrice monocristalline transférée.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
Les figures 1 à 8 illustrent un mode de réalisation possible du procédé selon l'invention ;
Les figures 9 et 10 illustrent la mise en œuvre d'une nouvelle séquence d'amorphisation/recristallisation ;
Les figures 11 et 12 illustrent une première variante d'amorphisation ;
La figure 13 illustre une autre variante d'amorphisation ;
La figure 14 représente une autre réalisation possible du substrat donneur à double couches d'arrêt à la gravure ;
La figure 15 représente une première amorphisation possible du substrat donneur de la figure 14 ;
La figure 16 représente une deuxième amorphisation possible du substrat donneur de la figure 14.

### DESCRIPTION DÉTAILLÉE

L'invention porte sur un procédé de réalisation d'un substrat de type semi-conducteur sur isolant par transfert d'une couche semi-conductrice sur un substrat receveur, une couche diélectrique étant présente à l'interface.

Dans une application privilégiée de l'invention, le procédé permet de concevoir un dispositif 3D à composants microélectroniques superposés avec un substrat receveur qui intègre des composants déjà fabriqués sur un premier niveau. La couche semi-conductrice à transférer est une couche rendue amorphe qui sera recristallisée à l'état monocristallin et pourra servir de couche active pour la fabrication de composants sur un niveau superposée au premier niveau. La couche semi-conductrice à transférer pourra constituer par exemple une région de canal pour un ou plusieurs transistors.

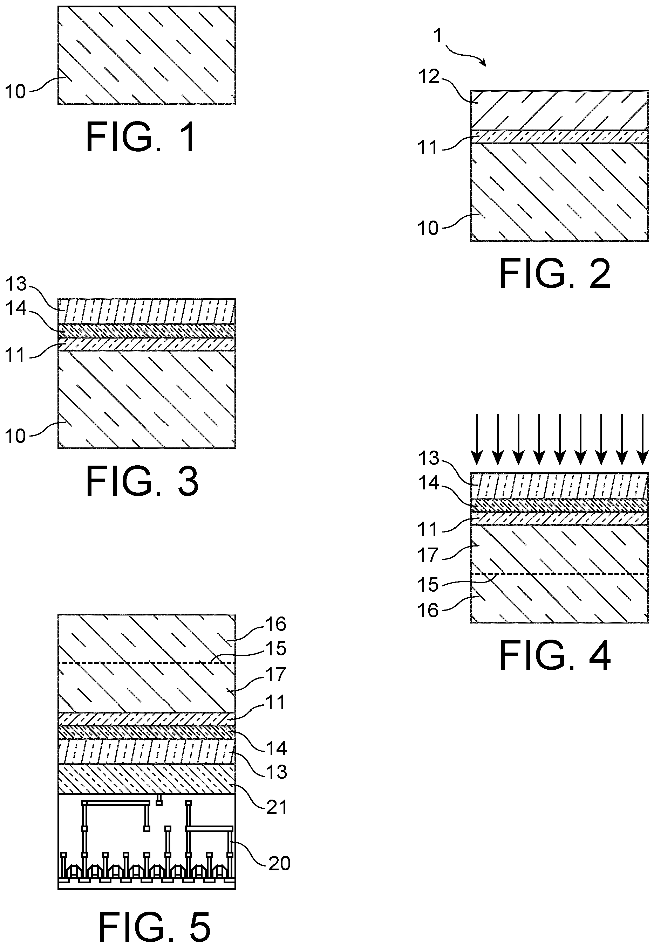

Une mise en œuvre possible du procédé selon l'invention est illustrée par les figures 1 à 8. En référence aux figures 1 et 2, le procédé débute par la fourniture d'un substrat support monocristallin 10. Une couche de lissage 11 et une couche semi-conductrice monocristalline 12 sont formées, par exemple successivement comme représenté sur la figure 2, par épitaxie sur le substrat support monocristallin. Un substrat donneur 1 est ainsi formé qui comprend le substrat support monocristallin 10, la couche de lissage 11 et la couche semi-conductrice monocristalline 12, cette dernière étant agencée en superficie dudit substrat.

La couche de lissage 11 forme une couche d'arrêt de gravure vis-à-vis du matériau du substrat support 10 et du matériau de la couche semi-conductrice monocristalline 12. À cet effet, la couche de lissage 11 est en un matériau présentant une composition chimique différente de celle du substrat support et de la couche semi-conductrice monocristalline, le choix des matériaux pouvant être effectué selon la nature de l'agent de gravure et de la sélectivité souhaitée.

Selon un mode de réalisation préféré, le substrat support 10 comprend un premier matériau identique à celui de la couche semi-conductrice monocristalline 12 et la couche de lissage 11 comprend un second matériau monocristallin différent du premier matériau. Le premier matériau est typiquement du silicium, le second matériau pouvant être du silicium-germanium.

L'épaisseur et la teneur en germanium de la couche de lissage 11 sont choisies de manière à obtenir une couche pseudomorphe, i.e. d'épaisseur inférieure à l'épaisseur critique de relaxation plastique, ce qui limite le risque de générer des défauts cristallins tels que des dislocations. Ainsi, l'épaisseur de la couche de lissage est typiquement comprise entre 5 et 120 nm. Selon une forme d'exécution particulière de l'invention, la teneur en germanium dans la couche de lissage est comprise entre 20 et 40%. L'épaisseur de la couche semi-conductrice monocristalline 12 est comprise entre 5 et 40 nm.

Selon un mode de réalisation, le substrat donneur est recouvert d'une couche diélectrique. Ladite couche diélectrique peut être en particulier une couche d'un oxyde ou d'un nitrure d'un matériau semi-conducteur. Ladite couche diélectrique formera tout ou partie de la couche isolante enterrée du substrat semi-conducteur sur isolant. Une formation possible de cette couche diélectrique sur le substrat donneur sera décrite par la suite.

De manière alternative, le substrat donneur n'est pas recouvert d'une telle couche diélectrique et c'est sa surface libre qui forme la surface du substrat donneur. Dans ce cas, la couche isolante enterrée du substrat sera constituée d'une couche diélectrique formée sur le substrat receveur auquel sera collé le substrat donneur en vue du transfert de la couche semi-conductrice.

En référence à la figure 3, le procédé comprend une amorphisation d'au moins une partie de la couche semi-conductrice 12. Cette amorphisation est réalisée par une implantation ionique, par exemple d'ions Ge ou Si, dont l'énergie et la dose sont sélectionnées en fonction de l'épaisseur de matériau à rendre amorphe.

Le processus d'amorphisation est connu pour générer une couche riche en atomes interstitiels proche de la partie rendue amorphe dans la partie sous-jacente demeurant cristalline. Dans l'exemple illustré par la figure 3, seule une partie superficielle de la couche semi-conductrice 12 est rendue amorphe (formant ainsi une couche amorphe 13) et on retrouve une couche riche en atomes interstitiels 14 entre la couche amorphe 13 et la couche de lissage 11.

La figure 4 illustre la mise en œuvre d'une implantation d'espèces ioniques, par exemple d'hydrogène et/ou d'hélium, dans le substrat support 10 de sorte à former un plan de fragilisation 15 délimitant une portion (formée de la couche amorphe 13, de la couche riche en atomes interstitiels 14, de la couche de lissage 11 et d'une partie 17 du substrat support) à transférer par le procédé Smart Cut^{™}.

En variante, ceci notamment dans le cas d'une couche de lissage 11 relativement épaisse (par exemple une couche de lissage 11 de SiGe avec une teneur de germanium comprise entre 20 et 25% et présentant une épaisseur comprise entre 50 et 120 nm), le plan de fragilisation 15 peut être réalisé au sein de la couche de lissage. Avec une telle variante, on évite ainsi l'étape de première gravure humide de la partie 17 du substrat support qui est décrite dans la suite du présent document.

L'amorphisation précédemment décrite peut, en variante, être réalisée après cette implantation d'espèces ioniques pour former le plan de fragilisation.

Lorsque l'amorphisation est réalisée avant l'implantation d'espèces ioniques, le procédé peut comprendre après l'amorphisation et avant l'implantation, le dépôt d'une ou plusieurs couches sur le substrat donneur, par exemple d'oxyde, de nitrure, de polysilicium dopé ou non. Ce dépôt est de préférence réalisé à une température permettant d'éviter une recristallisation de la couche amorphe, par exemple à une température inférieure à 500°C.

La figure 5 illustre le collage du substrat donneur avec le substrat receveur 20, une couche diélectrique 21 étant à l'interface de collage. Cette couche diélectrique 21 peut résulter de la formation préalable d'une couche diélectrique sur le substrat donneur et/ou sur le substrat receveur. Dans un mode privilégié de réalisation, le substrat receveur intègre des composants tels que des transistors.

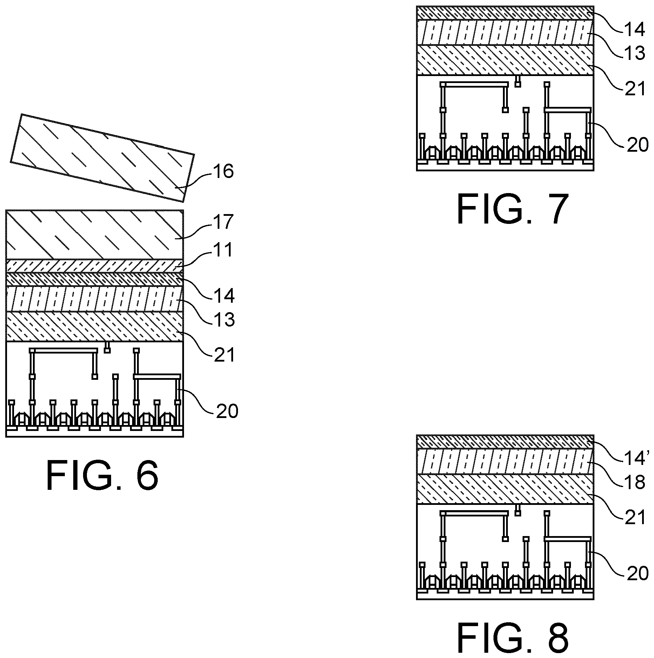

On procède par la suite au détachement du substrat donneur le long du plan de fragilisation 15, par exemple par apport d'énergie thermique. La figure 6 illustre la structure obtenue après ce détachement, la partie 17 du substrat support se retrouvant à la surface de ladite structure.

Après le transfert, la partie transférée du substrat donneur subit un traitement de finition réalisant un lissage (réduction de la rugosité) et un amincissement permettant d'atteindre l'épaisseur désirée pour la couche semi-conductrice transférée.

Ce traitement de finition comprend une première gravure humide de la partie 17 du substrat support, qui se trouve à la surface de la structure obtenue à l'issue du transfert, ladite gravure étant sélective vis-à-vis du matériau de la couche de lissage 11. Par exemple, si le substrat support est en silicium et la couche intermédiaire est en silicium germanium, l'agent de gravure peut être à base de TMAH ou de TEAH.

Dans l'exemple ici décrit, ce traitement de finition comprend une seconde gravure humide de la couche de lissage 11, qui se trouve à la surface de la structure obtenue à l'issue de la première gravure de la partie 17 du substrat support, ladite seconde gravure étant sélective vis-à-vis du matériau de la couche semi-conductrice. Par exemple, si la couche de lissage est en silicium germanium et la couche semi-conductrice est en silicium, l'agent de gravure peut être à base d'un mélange de CH₃COOH, de HF et de H₂O₂.

La figure 7 illustre la structure obtenue à l'issue de ces gravures. On y retrouve la couche amorphe 13 et la couche riche en atomes superficiels 14 supportées par le substrat receveur 20. L'avantage de ce traitement de finition est qu'il permet d'obtenir une couche semi-conductrice transférée présentant une épaisseur uniforme et une faible rugosité sans impliquer de budget thermique susceptible de dégrader des composants qui seraient intégrés dans le substrat receveur.

Le procédé se poursuit avec une étape de recristallisation en phase solide (SPER pour « Solid Phase Epitaxial Regrowth ») de l'au moins une partie de la couche semi-conductrice préalablement rendue amorphe, à savoir la couche 13 dans l'exemple ici décrit. Comme représenté en figure 8, la couche 13 est ainsi recristallisée et forme une couche semi-conductrice monocristalline transférée 18.

Cette recristallisation peut être obtenue au moyen d'un recuit à une température typiquement supérieure à 450°C, de préférence inférieure à 650°C, par exemple à 500°C, pendant une durée qui dépend de l'épaisseur de matériau à recristalliser. Cette durée est comprise entre quelques minutes pour un recuit à haute température pour la recristallisation d'une fine couche et une douzaine d'heures pour un recuit à plus basse température pour la recristallisation d'une couche plus épaisse.

La combinaison de l'amorphisation et de la recristallisation permet d'obtenir une couche transférée monocristalline 18 guérie de défauts générés par l'implantation ionique réalisée pour former le plan de fragilisation. Cette guérison est obtenue sans impliquer de budget thermique susceptible de dégrader des composants qui seraient intégrés dans le substrat receveur.

Cette étape de recristallisation en phase solide peut être mise en œuvre sous la forme d'un traitement de finition réalisé après détachement du substrat donneur le long du plan de fragilisation comme cela vient d'être précédemment décrit. Elle peut également être réalisée au cours du détachement au moyen de l'apport d'énergie thermique qui est alors fourni à l'assemblage des substrats donneur et receveur. Lorsque réalisée après détachement, cette étape de recristallisation peut être réalisée avant ou après la gravure de la couche de lissage 11. Lorsque réalisée avant cette gravure, elle est mise en œuvre à une température, par exemple comprise entre 500°C et 650°C, qui permet de ne pas générer de dislocations dans la couche de lissage.

Après la recristallisation, comme représenté en figure 8, la couche semi-conductrice monocristalline transférée 18 est surmontée par une couche 14' riche en atomes interstitiels. Dans un mode de réalisation possible, le procédé comprend une étape de retrait de cette couche 14' riche en atomes interstitiels. Cette étape de retrait comprend de préférence une oxydation de la couche 14' suivie d'un retrait de la couche 14' oxydée. L'oxydation peut comprendre une oxydation chimique, de préférence, basse température de la couche 14'. L'oxydation peut également comprendre une oxydation assistée par plasma, de préférence basse température (par exemple entre 400°C et 450°C). Le retrait de la couche 14' oxydée peut comprendre une gravure chimique, par exemple à base de HF.

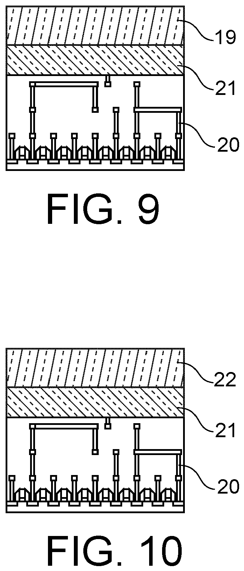

Dans un autre mode de réalisation possible illustré sur les figures 9 et 10, après la recristallisation et préférentiellement après la gravure de la couche de lissage, le procédé comprend une amorphisation additionnelle qui va conduire à la formation d'une nouvelle couche superficielle rendue amorphe 19. Cette amorphisation additionnelle est ainsi réalisée de manière à conserver un germe cristallin à proximité de la couche d'oxyde 21. Cette amorphisation additionnelle est suivie d'une recristallisation en phase solide additionnelle qui va conduire à une nouvelle couche mince monocristalline transférée 22.

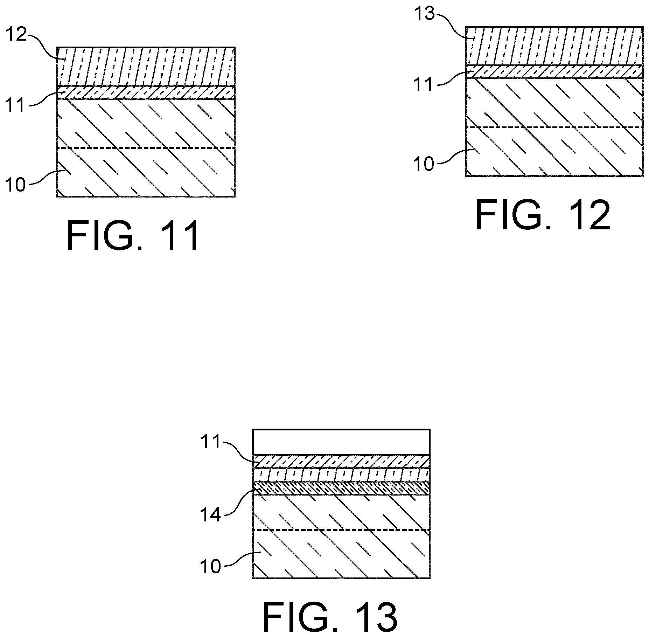

Dans un autre mode de réalisation illustré sur les figures 11 et 12, le procédé comprend une amorphisation de l'intégralité de la couche semi-conductrice 12 conduisant à une couche amorphe 13. Cette amorphisation peut être précédée d'une amorphisation sélective de la couche de lissage 11 par rapport à la couche semi-conductrice 12. L'amorphisation sélective de la couche de lissage est rendue possible par le fait qu'elle est atteinte à plus faible dose que l'amorphisation de la couche semi-conductrice 12.

Dans un autre mode de réalisation illustré par la figure 13, l'amorphisation d'au moins une partie de la couche semi-conductrice comprend l'amorphisation conjointe de la couche semi-conductrice, de la couche de lissage et éventuellement d'une partie du substrat support 10 de manière à ce que la couche riche en atomes interstitiels 14 soit localisée dans le substrat support 10. Cette couche 14 est ultérieurement retirée par la gravure sélective de la partie transférée du substrat support exploitant la couche de lissage 11 comme couche d'arrêt.

Lorsque la recristallisation est opérée en présence de la couche de lissage, un risque existe que la couche de lissage, qui est soumise lors de la recristallisation à des contraintes biaxiales compressives pour conserver le paramètre de maille du matériau de la couche semi-conductrice, vienne relâcher ses contraintes en formant des dislocations. Ces dislocations sont susceptibles de se propager dans la couche semi-conductrice monocristalline transférée 18 et donc de dégrader la performance de composants qui seraient ultérieurement réalisés au moyen de cette couche. Pour réduire le risque de formation de ces dislocations, une couche de lissage plus fine peut être utilisée, présentant par exemple une épaisseur inférieure à 20 nm, de préférence inférieure à 15 nm pour une couche présentant une teneur en germanium de 20%, ou encore une épaisseur inférieure à 15 nm, de préférence inférieure à 10 nm pour une couche présentant une teneur en germanium de 25%, ou encore une épaisseur inférieure à 10 nm, de préférence inférieure à 5 nm pour une couche présentant une teneur en germanium de 30%.

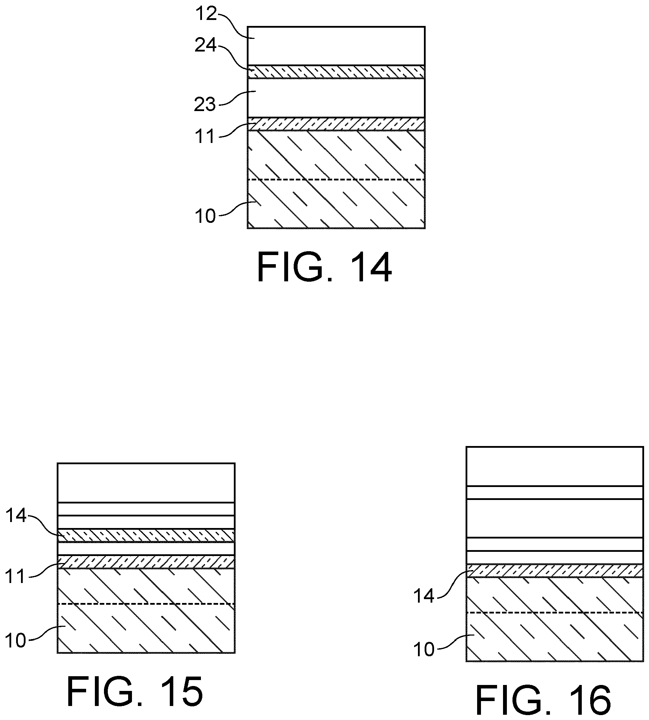

Avec une telle finesse, la couche de lissage pourrait ne pas être suffisamment robuste pour la gravure sélective du traitement de finition visant à la fois au lissage et à l'amincissement. Une solution pour contourner cette difficulté consiste à ne conférer à la couche de lissage 11 qu'une fonction de lissage et à la doubler d'une couche d'amincissement 24, également pseudomorphe, dédiée à l'amincissement permettant d'atteindre l'épaisseur désirée pour la couche semi-conductrice transférée. À cet effet, comme représenté à la figure 14, le substrat donneur comprend en outre une couche intermédiaire 23 (par exemple en silicium) et ladite couche d'amincissement 24 (par exemple en silicium-germanium) interposée entre la couche intermédiaire 23 et la couche semi-conductrice 12. La couche d'amincissement 24 forme une couche d'arrêt à la gravure vis-à-vis du matériau de la couche semi-conductrice. L'étape de finition comprend ainsi la réalisation successive d'une gravure sélective de la couche de lissage 11 par rapport à la couche intermédiaire 23, d'une gravure sélective de la couche intermédiaire 23 par rapport à la couche d'amincissement 24 et d'une gravure sélective de la couche d'amincissement 24 par rapport à la couche semi-conductrice 12.

Comme représenté en figure 15, l'amorphisation d'au moins une partie de la couche semi-conductrice peut alors comprendre l'amorphisation conjointe de la couche semi-conductrice 12 et de la couche d'amincissement 24 de manière à ce que la couche riche en atomes interstitiels 14 soit localisée entre la couche d'amincissement 24 et la couche de lissage 11. La couche de lissage 11 n'étant pas rendue amorphe, elle n'a pas à être recristallisée et ne vient donc pas générer des dislocations lors de la recristallisation. Elle peut donc être plus épaisse et/ou de concentration en germanium plus importante, rendant de ce fait la gravure sélective plus stable en performance. La couche d'amincissement 24 peut quant à elle être relativement fine car la rugosité est déjà largement rattrapée à l'aide de la couche de lissage. En formant une couche d'arrêt à la gravure, elle permet d'éliminer facilement la couche riche en atomes interstitiels.

Comme représenté en figure 16, l'amorphisation d'au moins une partie de la couche semi-conductrice peut également comprendre l'amorphisation conjointe de la couche semi-conductrice 12, de la couche d'amincissement 24, de la couche intermédiaire 23 et de la couche de lissage 11 de manière à ce que la couche riche en atomes interstitiels 14 soit localisée dans le substrat support.

On a vu précédemment que le substrat donneur pouvait être recouvert d'une couche d'oxyde, celle-ci étant notamment destinée à constituer une zone tampon entre l'interface de collage et les composants restant à fabriquer dans le deuxième niveau de manière à ce que ceux-ci disposent de caractéristiques électriques optimales comme par exemple une faible densité d'états de surface à l'interface entre la couche active et la couche d'oxyde.

Une première difficulté tient à la présence de la couche de lissage typiquement en silicium-germanium qui fait qu'un budget thermique d'oxydation trop important ne doit pas être apporté afin d'éviter une diffusion du germanium et un relâchement des contraintes (formation de dislocations) de la couche de silicium-germanium. En pratique, la température ne doit pas excéder 800°C, en étant de préférence dans la gamme 700-750°C. La cinétique du processus d'oxydation est alors réduite et l'obtention de couches plus épaisses que 15 nm peut nécessiter une durée prohibitive.

Une autre difficulté tient à l'amorphisation d'une couche cristalline de silicium à travers une couche d'oxyde en SiO₂, cette amorphisation venant créer une couche de transition à l'interface. Plus la couche d'oxyde est épaisse, plus les atomes d'oxygène se retrouvent présents en quantité dans la couche de silicium et plus l'efficacité de la recristallisation SPER se retrouve réduite.

Afin de contourner ces difficultés, l'invention propose dans un mode de réalisation possible de venir former, avant l'amorphisation d'au moins une partie de la couche semi-conductrice, une fine couche diélectrique au moyen d'un traitement thermique basse température. Il s'agit par exemple de venir former une couche diélectrique d'épaisseur comprise par exemple entre 5 nm et 25 nm par oxydation thermique à une température de préférence inférieure à 800°C. Cette couche diélectrique peut ensuite, après l'amorphisation d'au moins une partie de la couche semi-conductrice, faire l'objet d'un épaississement au moyen du dépôt d'un diélectrique à basse température, par exemple du SiN ou du SiO₂ déposé par PECVD. Ce dépôt peut ainsi être réalisé à une température allant jusqu'à 500°C s'il est réalisé avant la formation du plan de fragilisation par implantation H/He. Il peut être réalisé à une température inférieure à 250°C dans le cas contraire.

## Revendications

1. Procédé de réalisation d'un substrat de type semi-conducteur sur isolant, comprenant les étapes suivantes :
a) fourniture d'un substrat donneur (1) comprenant un substrat support (10) monocristallin, une couche de lissage (11) et une couche semi-conductrice (12), la couche de lissage formant une couche d'arrêt à la gravure vis-à-vis du matériau du substrat support ;
a') implantation d'espèce ioniques au travers de la couche semi-conductrice (12) de sorte à former un plan de fragilisation (15) ;
b) réalisation d'un assemblage par mise en contact du substrat donneur et d'un substrat receveur (20);
c) transfert sur le substrat receveur de la couche semi-conductrice (12) et d'au moins une partie de la couche de lissage (11) par détachement le long du plan de fragilisation (15) ;
ledit procédé étant **caractérisé en ce que** la couche semi-conductrice (11) du substrat donneur fourni à l'étape a) est monocristalline et **en ce qu'**il comprend en outre les étapes suivantes :
- avant l'étape b), amorphisation d'au moins une partie de la couche semi-conductrice pour former une couche amorphe (13) ;
- pendant ou après l'étape c), recristallisation en phase solide de la couche amorphe (13) pour former une couche semi-conductrice monocristalline transférée (18).

2. Procédé selon la revendication 1, dans lequel ladite recristallisation est suivie d'une amorphisation de la couche semi-conductrice monocristalline transférée (18) pour former une nouvelle couche amorphe (19) et d'une recristallisation en phase solide de la nouvelle couche amorphe (19) pour former une nouvelle couche semi-conductrice monocristalline transférée (22).

3. Procédé selon la revendication 1, comprenant en outre un retrait d'une couche riche en atomes interstitiels (14') présente en surface de la couche semi-conductrice monocristalline transférée (18).

4. Procédé selon la revendication 3, dans lequel ledit retrait comprend une oxydation assistée par plasma suivie d'une gravure chimique.

5. Procédé selon la revendication 1, dans lequel l'amorphisation d'au moins une partie de la couche semi-conductrice comprend l'amorphisation de l'intégralité de la couche semi-conductrice (12).

6. Procédé selon la revendication 1, dans lequel l'amorphisation d'au moins une partie de la couche semi-conductrice comprend l'amorphisation conjointe de la couche semi-conductrice (12) et de la couche de lissage (11).

7. Procédé selon la revendication 1, dans lequel le substrat donneur fourni à l'étape (a) comprend en outre une couche intermédiaire (23) et une couche d'amincissement (24) interposée entre la couche intermédiaire (23) et la couche semi-conductrice (12), la couche d'amincissement (24) formant une couche d'arrêt à la gravure vis-à-vis du matériau de la couche semi-conductrice (12) et dans lequel l'étape d) comprend en outre la réalisation successive d'une gravure sélective de la couche de lissage (11) par rapport à la couche intermédiaire (23), d'une gravure sélective de la couche intermédiaire (23) par rapport à la couche d'amincissement (24) et d'une gravure sélective de la couche d'amincissement (24) par rapport à la couche semi-conductrice (12).

8. Procédé selon la revendication 7, dans lequel l'amorphisation d'au moins une partie de la couche semi-conductrice comprend l'amorphisation conjointe de la couche semi-conductrice (12) et d'au moins une partie de la couche d'amincissement (24).

9. Procédé selon la revendication 7, dans lequel l'amorphisation d'au moins une partie de la couche semi-conductrice comprend l'amorphisation conjointe de la couche semi-conductrice (12), de la couche d'amincissement (24) et d'au moins une partie de la couche intermédiaire (23).

10. Procédé selon la revendication 7, dans lequel l'amorphisation d'au moins une partie de la couche semi-conductrice comprend l'amorphisation conjointe de la couche semi-conductrice (12), de la couche d'amincissement (24), de la couche intermédiaire (23) et d'au moins une partie de la couche de lissage (11).

11. Procédé selon l'une quelconque des revendications 1 à 10, dans lequel lors de l'étape a') d'implantation d'espèce ioniques, le plan de fragilisation (15) est formé dans le substrat support, et dans lequel le procédé comprend en outre, après l'étape c) de transfert, l'étape suivante:
d) la réalisation d'une gravure sélective de ladite partie (17) du substrat support par rapport à la couche de lissage (11).

12. Procédé selon la revendication 11, dans lequel l'étape d) comprend en outre la réalisation d'une gravure sélective de la couche de lissage (11).

13. Procédé selon l'une quelconque des revendications 1 à 10, dans lequel lors de l'étape a') d'implantation d'espèce ioniques, le plan de fragilisation (15) est formé dans la couche de lissage.

14. Procédé selon l'une des revendications 1 à 13, comprenant avant l'amorphisation d'au moins une partie de la couche semi-conductrice, la formation sur la couche semi-conductrice, par oxydation thermique à une température inférieure à 800°C, d'une couche diélectrique d'épaisseur comprise entre 5 nm et 25 nm, ladite couche diélectrique étant à l'étape b) à l'interface des substrats donneur et receveur mis en contact.

15. Procédé selon la revendication 14, dans lequel ladite formation comprend en outre, après l'amorphisation d'au moins une partie de la couche semi-conductrice, un épaississement de la couche diélectrique.

## Patentansprüche

1. Verfahren zur Realisation eines Substrats vom Typ Halbleiter auf Isoliermedium, die folgenden Schritte umfassend:
a) Bereitstellen eines Donatorsubstrats (1), das ein monokristallines Trägersubstrat (10), eine Glättungsschicht (11) und eine halbleitende Schicht (12) umfasst, wobei die Glättungsschicht gegen das Material des Trägersubstrats eine Ätzsperrschicht bildet;
a') Implantation von ionischer Spezies durch die halbleitende Schicht (12), um eine Versprödungsebene (15) zu bilden;
b) Realisation einer Verbindung durch in Kontakt bringen des Donatorsubstrats mit einem Empfängersubstrat (20);
c) Transfer auf das Empfängersubstrat der halbleitenden Schicht (12) und mindestens eines Teils der Glättungsschicht (11) durch Ablösung entlang der Versprödungsebene (15);
wobei das Verfahren **dadurch gekennzeichnet ist, dass** die halbleitende Schicht (11) des im Schritt a) bereitgestellten Donatorsubstrats monokristallin ist und ferner die folgenden Schritte umfasst:
- vor dem Schritt b), Amorphisierung von mindestens einem Teil der halbleitenden Schicht, um eine amorphe Schicht (13) zu bilden;
- während oder nach dem Schritt c), Rekristallisation in die feste Phase der amorphen Schicht (13), um eine transferierte monokristalline halbleitende Schicht (18) zu bilden.

2. Verfahren nach Anspruch 1, wobei die Rekristallisation von einer Amorphisierung der transferierten monokristallinen halbleitenden Schicht (18) gefolgt ist, um eine neue amorphe Schicht (19) zu bilden, und von einer Rekristallisation in die feste Phase der neuen amorphen Schicht (19), um eine neue transferierte monokristalline halbleitende Schicht (22) zu bilden.

3. Verfahren nach Anspruch 1, ferner eine Schwindung einer an Zwischengitteratomen reichen Schicht (14') umfassend, die auf der Oberfläche der transferierten monokristallinen halbleitenden Schicht (18) vorhanden ist.

4. Verfahren nach Anspruch 3, wobei die Schwindung eine plasmaunterstützte Oxidation umfasst, die von einer chemischen Ätzung gefolgt ist.

5. Verfahren nach Anspruch 1, wobei die Amorphisierung mindestens eines Teils der halbleitenden Schicht die Amorphisierung der gesamten halbleitenden Schicht (12) umfasst.

6. Verfahren nach Anspruch 1, wobei die Amorphisierung mindestens eines Teils der halbleitenden Schicht die gemeinsame Amorphisierung der halbleitenden Schicht (12) und der Glättungsschicht (11) umfasst.

7. Verfahren nach Anspruch 1, wobei das im Schritt (a) bereitgestellte Donatorsubstrat ferner eine Zwischenschicht (23) und eine Ausdünnschicht (24) umfasst, die zwischen der Zwischenschicht (23) und der halbleitenden Schicht (12) liegt, wobei die Ausdünnschicht (24) eine Ätzsperrschicht gegen das Material der halbleitenden Schicht (12) bildet, und wobei der Schritt d) ferner die sukzessive Realisation einer selektiven Ätzung der Glättungsschicht (11) gegenüber der Zwischenschicht (23), einer selektiven Ätzung der Zwischenschicht (23) gegenüber der Ausdünnschicht (24) und einer selektiven Ätzung der Ausdünnschicht (24) gegenüber der halbleitenden Schicht (12) umfasst.

8. Verfahren nach Anspruch 7, wobei die Amorphisierung mindestens eines Teils der halbleitenden Schicht die gemeinsame Amorphisierung der halbleitenden Schicht (12) und mindestens eines Teils der Ausdünnschicht (24) umfasst.

9. Verfahren nach Anspruch 7, wobei die Amorphisierung mindestens eines Teils der halbleitenden Schicht die gemeinsame Amorphisierung der halbleitenden Schicht (12), der Ausdünnschicht (24) und mindestens eines Teils der Zwischenschicht (23) umfasst.

10. Verfahren nach Anspruch 7, wobei die Amorphisierung mindestens eines Teils der halbleitenden Schicht die gemeinsame Amorphisierung der halbleitenden Schicht (12), der Ausdünnschicht (24), der Zwischenschicht (23) und mindestens eines Teils der Glättungsschicht (11) umfasst.

11. Verfahren nach einem der Ansprüche 1 bis 10, wobei, während dem Schritt a') der Implantation von ionischer Spezies, die Versprödungsebene (15) im Trägersubstrat gebildet wird, und wobei das Verfahren ferner, nach dem Schritt c) des Transfers, den folgenden Schritt umfasst:
d) die Realisation einer selektiven Ätzung des Teils (17) des Trägersubstrats gegenüber der Glättungsschicht (11).

12. Verfahren nach Anspruch 11, wobei der Schritt d) ferner die Realisation einer selektiven Ätzung der Glättungsschicht (11) umfasst.

13. Verfahren nach einem der Ansprüche 1 bis 10, wobei, während dem Schritt a') der Implantation von ionischer Spezies, die Versprödungsebene (15) in der Glättungsschicht gebildet wird.

14. Verfahren nach einem der Ansprüche 1 bis 13, umfassend, vor der Amorphisierung mindestens eines Teils der halbleitenden Schicht, die Bildung einer dielektrischen Schicht mit einer Dicke zwischen 5 nm und 25 nm, auf der halbleitenden Schicht, durch thermische Oxidation bei einer Temperatur von weniger als 800 °C, wobei die dielektrische Schicht im Schritt b) an der Schnittstelle der in Kontakt gebrachten Donator- und Empfängersubstrate ist.

15. Verfahren nach Anspruch 14, wobei die Bildung ferner, nach der Amorphisierung mindestens eines Teils der halbleitenden Schicht, eine Verdickung der dielektrischen Schicht umfasst.

## Claims

1. Method for creating a substrate of the type semiconductor on insulator, comprising the following steps:
a) providing a donor substrate (1) comprising a monocrystalline support substrate (10), a smoothing layer (11) and a semiconductor layer (12), the smoothing layer forming an etch stop layer with respect to the material of the support substrate;
a') implantation of ion species through the semiconductor layer (12) so as to form a fragilisation plane (15) ;
b) creating an assembly by placing the donor substrate and a receiver substrate (20) in contact;
c) transferring the semiconductor layer (12), and at least a part of the smoothing layer (11) onto the receiver substrate by detachment along the fragilization plane;
d) carrying out a selective etching of said part (17) of the support substrate with respect to the smoothing layer (11);
said method being **characterised in that** the semiconductor layer (11) of the donor substrate provided in step a) is monocrystalline and **in that** it further comprises the following steps:
- before step b), amorphisation of at least a part of the semiconductor layer to form an amorphous layer (13);
- during or after step c), recrystallisation in solid phase of the amorphous layer (13) to form a transferred monocrystalline semiconductor layer (18).

2. Method according to claim 1, wherein said recrystallisation is followed by an amorphisation of the transferred monocrystalline semiconductor layer (18) to form a new amorphous layer (19) and by a recrystallisation in solid phase of the new amorphous layer (19) to form a new transferred monocrystalline semiconductor layer (22).

3. Method according to claim 1, further comprising a removal of a layer rich in interstitial atoms (14'), present on the surface of the transferred monocrystalline semiconductor layer (18).

4. Method according to claim 3, wherein said removal comprises plasma-assisted oxidation followed by chemical etching.

5. Method according to claim 1, wherein the amorphisation of at least a part of the semiconductor layer comprises the amorphisation of the entirety of the semiconductor layer (12).

6. Method according to claim 1, wherein the amorphisation of at least a part of the semiconductor layer comprises the joint amorphisation of the semiconductor layer (12) and of the smoothing layer (11).

7. Method according to claim 1, wherein the donor substrate provided in step a) further comprises an intermediate layer (23) and a thinning layer (24) interposed between the intermediate layer (23) and the semiconductor layer (12), the thinning layer (24) forming an etch stop layer with respect to the material of the semiconductor layer (12) and wherein step d) further comprises the successive carrying out of a selective etching of the smoothing layer (11) with respect to the intermediate layer (23), of a selective etching of the intermediate layer (23) with respect to the thinning layer (24) and of a selective etching of the thinning layer (24) with respect to the semiconductor layer (12).

8. Method according to claim 7, wherein the amorphisation of at least a part of the semiconductor layer comprises the joint amorphisation of the semiconductor layer (12) and of at least a part of the thinning layer (24).

9. Method according to claim 7, wherein the amorphisation of at least a part of the semiconductor layer comprises the joint amorphisation of the semiconductor layer (12), of the thinning layer (24) and of at least a part of the intermediate layer (23).

10. Method according to claim 7, wherein the amorphisation of at least a part of the semiconductor layer comprises the joint amorphisation of the semiconductor layer (12), of the thinning layer (24), of the intermediate layer (23) and of at least a part of the smoothing layer (11).

11. Method according to one of claims 1 to 10, wherein during the step a') of implantation of ion species, the fragilization plane (15) is formed in the support substrate, and wherein the method further comprises, after step c) of transferring, the following step:
d) carrying out a selective etching of said part (17) of the support substrate with respect to the smoothing layer (11).

12. Method according to claim 11, wherein step d) further comprises performing of selective etching of the smoothing layer (11).

13. Method according to one of claims 1 to 10, wherein during step a') of implantation of ionic species, the fragilization plan (15) is formed in the smoothing layer.

14. Method according to one of claims 1 to 13, comprising, before the amorphization of at least a part of the semiconductor layer, the formation on the semiconductor layer, by thermal oxidation at a temperature lower than 800°C, of a dielectric layer having a thickness between 5 nm and 25 nm, said dielectric layer being in step b) at the interface of the donor and receiver substrates placed in contact.

15. Method according to claim 14, wherein said formation further comprises, after the amorphization of at least a part of the semiconductor layer, a thickening of the dielectric layer.
